# EUROPEAN PATENT SPECIFICATION

(11) **EP 1 698 016 B1**
(45) Date of publication and mention of the grant of the patent: **03.09.2008**
(21) Application number: 04815964.4
(22) Date of filing: 23.12.2004
(51) Int. Cl.: H01P 1/04

(54) **TRIANGULAR CONFORMING TRANSMISSION STRUCTURE**
DREIECKIGE KONFORME ÜEBRTRAGUNGSSTRUKTUR
STRUCTURE DE TRANSMISSION A CONFORMATION TRIANGULAIRE

(30) Priority: 24.12.2003 US 532719 P
(43) Date of publication of application: 06.09.2006
(73) Proprietor: MOLEX INCORPORATED, Lisle, IL 60532 (US)
(72) Inventor: BRUNKER, David, L., Naperville, IL 60565 (US)
(74) Representative: Evans, Huw David Duncan
(86) International application number: PCT/US2004/043977
(87) International publication number: WO 2005/067092

(56) References cited:
- EP-A- 0 343 771
- US-A- 3 496 492
- US-A- 6 154 103
- PATENT ABSTRACTS OF JAPAN vol. 013, no. 348 (E-799), 4 August 1989 (1989-08-04) & JP 01 106602 A (FUJITSU LTD), 24 April 1989 (1989-04-24)

## Description

### Background Of The Invention

The present invention pertains to multi-circuit electronic communication systems, and more particularly, to a dedicated transmission channel structure for use in such systems and which can be utilized in all parts of a transmission system, chip packaging, circuit board construction, interconnect devices and launches for such systems.

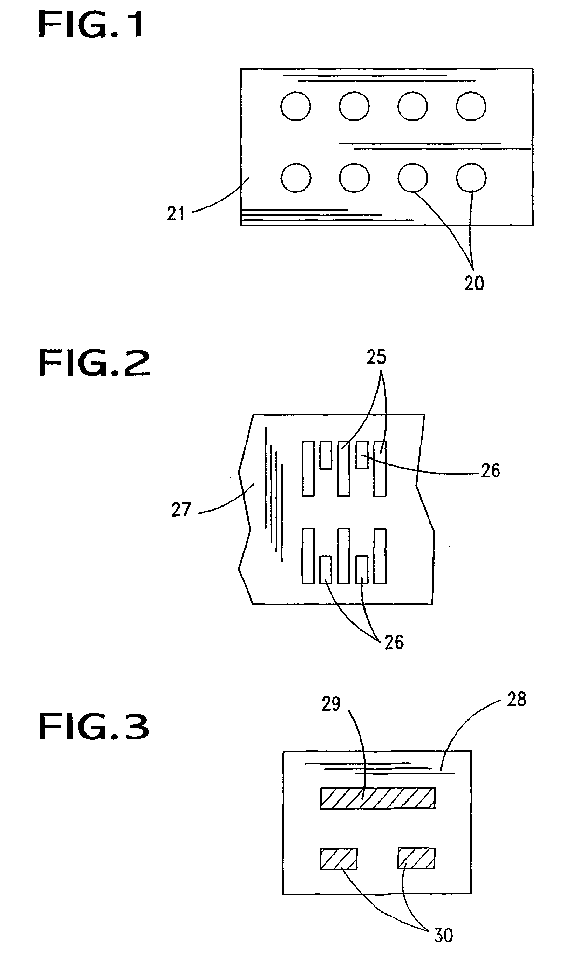

Various means of electronic transmission are known in the art. Most, if not all of these transmission means, suffer from inherent speed limitations such as both the upper frequency limit and the actual time a signal requires to move from one point to another within the system, which is commonly referred to as propagation delay. They simply are limited in their electronic performance primarily by their structure, and secondarily by their material composition. One traditional approach utilizes conductive pins, such as those found in an edge card connector as is illustrated in FIG. 1. In this type of structure a plurality of conductive pins, or terminals 20, are arranged within a plastic housing 21 and this arrangement provides operational speeds of about 800 to 900 MHz. An improvement upon this standard structure is represented by edge card connectors that may be known in the art as "Hi-Spec" and which are illustrated in FIG. 2, in which the system includes large ground contacts 25 and small signal contacts 26 disposed within an insulative connector housing 27. The smaller signal contacts 26 couple to the larger ground contacts 25. The signal contacts in these structures are not differential signal contacts, but are merely single-ended signal, meaning that every signal contact is flanked by a ground contact. The operational speeds for this type of system are believed to be about 2.3 Ghz.

Yet another improvement in this field is referred to as a "triad" or "triple" connector in which conductive terminals are disposed within a plastic housing 28 in a triangular pattern, and the terminals include a large ground terminal 29, and two smaller differential signal terminals 30, as illustrated in FIG. 3, and, as described in greater detail U.S. Pat. No. 6,280,209. This triad/triple structure has an apparent upper limit speed of about 4 Ghz. All three of these approaches utilize, in the simplest sense, conductive pins in a plastic housing in order to provide a transmission line for electronic signals.

In each of these type constructions, it is desired to maintain a dedicated transmission structure through the entire delivery path of the system, including through the circuit board(s), the mating interface and the source and load of the system. It is difficult to achieve the desired uniformity within the system when the transmission system is constructed from individual pins. Discrete point-to-point connections are used in these connectors for signal, ground and power. Each of these conductors was designed as either a conductor or a means of providing electrical continuity and usually did not take into account transmission line effects. Most of the conductors were designed as a standard pinfield so that all the pins, or terminals, were identical, regardless of their designated electrical function and the pins were further arranged at a standard pitch, material type and length. Although satisfactory in performance at low operating speeds, at high operational speeds, these systems would consider the conductors as discontinuities in the system that affect the operation and speed thereof

Many signal terminals or pins in these systems were connected to the same ground return conductor, and thus created a high signal to ground ratio, which did not lend themselves to high-speed signal transmission because large current loops are forced between the signals and the ground, which current loops reduce the bandwidth and increase the cross talk of the system, thereby possibly degrading the system performance.

Bandwidth **("BW")** is proportional to **1**/√(**LC**), where **L** is the inductance of the system components, **C** is the capacitance of the system components and **BW** is the bandwidth. The inductive and capacitive components of the signal delivery system work to reduce the bandwidth of the system, even in totally homogeneous systems without discontinuities. These inductive and capacitive components can be minimized by reducing the overall path length through the system, primarily through limiting the area of the current path through the system and reducing the total plate area of the system elements. However, as the transmission frequency increases, the reduction in size creates its own problem in that the effective physical length is reduced to rather small sizes. High frequencies in the 10 Ghz range and above render most of the calculated system path lengths unacceptable.

In addition to aggregate inductance and capacitance across the system being limiting performance factors, any non-homogeneous geometrical and/or material transitions create discontinuities. Using about 3.5 Ghz as a minimum cutoff frequency in a low voltage differential signal system operating at around 12.5 Gigabits per second (Gbps), the use of a dielectric with a dielectric constant of about 3.8 will yield a critical path length of about 0.25 inches, over which length discontinuities may be tolerated. This dimension renders impracticable the ability of one to construct a system that includes a source, transmission load and load within the given quarter-inch. It can thus be seen that the evolution of electronic transmission structures have progressed from uniform-structured pin arrangements to functionally dedicated pins arrangements to attempted unitary structured interfaces, yet the path length and other factors still limit these structures. With the aforementioned prior art structures, it was not feasible to carry high frequency signals due to the physical restraints of these systems and the short critical path lengths needed for such transmission.

In order to obtain an effective transmission structure, one must maintain a constant and dedicated transmission line over the entire delivery path: from the source, through the interface and to the load. This would include the matable interconnects and printed circuit boards and the interconnect signal launch into and out from the printed circuit board or other transmission media such as cables and even the semiconductor device chip packaging. This is very difficult to achieve when the delivery system is constructed from individual, conductive pins designed to interconnect with other individual conductive pins because of potential required changes in the size, shape and position of the pins/terminals with respect to each other. For example, in a right angle connector, the relationship between the rows of pins/terminals change in both the length and the electrical coupling. High speed interconnect design principles that include all areas between the source and load of the system including chip packaging, printed circuit boards, board connectors and cable assemblies are being used in transmission systems with sources of up to 2.5 Gbps. One such principle is the principle of ground by design, which provides added performance over a standard pin field in that coupling is enhanced between the signal and ground paths and single-ended operation is complimented. Another principle being used in such systems includes impedance tuning to minimize discontinuities. Yet another design principle is pin out optimization where signal and return paths are assigned to specific pins in the pin field to maximize the performance. These type of systems all are limited with respect to attaining the critical path lengths mentioned above.

U.S. Patent No. 6,154,103 discloses a connector for a superconductive cable or socalled cyrocable that is supercooled. The connector comprises a cut-out end which exposes a centre conductor of the cable. The other conductor of the cable comprises a bifurcated end having arms which extend on opposite sides of the cut-out.

The present invention is directed to an improved transmission or delivery system that overcomes the aforementioned disadvantages and which operates at higher speeds.

### Summary of the Invention

The present directed is therefore directed to an improved transmission structure that overcomes the aforementioned disadvantages and utilizes grouped electrically conductive elements to form a unitary mechanical structure that provides a complete electronic transmission channel that is similar in one sense to a fiber optic system. The focus of the invention is on providing a complete, engineered copper-based electronic transmission channel rather than utilizing either individual conductive pins or separable interfaces with copper conductors as the transmission channel, the transmission channels of the invention yielding more predictable electrical performance and greater control of operational characteristics. Such improved systems of the present invention are believed to offer operating speeds for digital signal transmission of up to at least 12.5 GHz at extended path lengths which are much greater than 0.25 inch.

Accordingly, it is a general object of the present invention to provide an engineered waveguide that functions as a grouped element channel link, where the link includes an elongated dielectric body portion and at least two conductive elements disposed along the exterior surface thereof.

Another object of the present invention is to provide a high-speed channel link (or transmission line) having an elongated body portion of a given cross-section, the body portion being formed from a dielectric with a selected dielectric constant, and the link having, in its most basic structure, two conductive elements disposed on the exterior surface thereof, the elements being of similar size and shape and oriented thereon, in opposition to each other, so as to steer the electrical energy wave traveling through the link by establishing particular electrical and magnetic fields between the two conductive elements and maintaining these fields throughout the length of the channel link.

A further object of the present invention is to control the impedance of the channel link by selectively sizing the conductive elements and the gaps therebetween on the exterior surface of the elongated body to maintain balanced or unbalanced electrical & magnetic fields.

Yet another object of the present invention is to provide a improved electrical transmission channel that includes a flat substrate, and a plurality of grooves formed in the substrate, the grooves having opposing sidewalls and the grooves being spaced apart by intervening lands of the substrate, the sidewalls of the grooves having a conductive material deposited thereon, such as by plating or deposition, to form electronic transmission channels within the grooves.

A still further object of the present invention is to provide a pre-engineered wave guide in which at least a pair of conductive elements are utilized to provide differential signal transmission, i.e., signal in ("+") and signal out ("-"), the pair of conductive elements being disposed on the exterior of the dielectric body so as to permit the establishment of capacitance per unit length, inductance per unit length, impedance, attenuation and propagation delay per unit length, and establishing these pre-determined performance parameters within the channels formed by the conductive elements.

A yet further object of the present invention is to provide an improved transmission line in the form of a solid link, of preferably uniform, circular cross-section, the link including at least a pair of conductive elements disposed thereon that serve to guide the electrical wave therethrough, the link including at least one thin filament of dielectric material having two conductive surfaces disposed thereon, the conductive surfaces extending lengthwise of the filament and separated by two circumferential arcuate extents, the conductive surfaces further being separated from each other to form a discrete, two-element transmission channel that reduces the current loop and in which the signal conductors are more tightly aligned.

Yet another object of the present invention is to provide a non-circular transmission line for high speed applications, which includes an elongated rectangular or square dielectric member having an exterior surface with at least four distinct sectors disposed thereon, the dielectric member including a pair of conductive elements aligned with each other and disposed on two of the sectors, while separated by an intervening sector.

The present invention accomplishes the above and other objects by virtue of its unique structure. In one principal aspect, the present invention includes a transmission line that is formed from a dielectric, through which conductors are spaced and arranged to conform to the aforementioned triangular conductor pattern of a "triad" connector. The triangular "triad" conductor pattern is accomplished by spacing the electrodes using a slot is cut or formed through dielectric. At the top edge of each side of the slot and just outside the slot, a thin, narrow strip of conductive material is deposited on each side of the slot. A thin strip of conductive material is deposited at the bottom of the slot. By sizing the depth and width of the slot, the transmission line conductors along the slot's top edges and the bottom can be precisely matched to the triangular spacing used in virtually any "triad" conductor. By matching the transmission line's conductors to a "triad" connector, impedance discontinuities at a "triad" connector/transmission line interface can be reduced or eliminated.

### Brief Description Of The Drawings

In the course of this detailed description, the reference will be frequently made to the attached drawings in which:
FIG. 1 is a schematic plan view of the terminating face of a conventional connector;
FIG. 2 is a schematic plan view of an edge card used in a high speed connector;
FIG. 3 is a schematic elevational view of a high speed connector utilizing a triad or triple;
FIG. 4 is a perspective view of a grouped element channel link constructed in accordance with the principles of the present invention.
FIG. 5 is a schematic end view of the grouped element channel link of FIG. 4 illustrating the arcuate extents of the conductive elements and the spacing there between;
FIG. 6 is a perspective view of an alternate embodiment of a grouped element channel link constructed in accordance with the principles of the present invention.
FIG. 7 is a schematic view of a transmission link of the present invention used to connect a source with a load having intermediate loads on the transmission link;
FIG. 8 is a schematic view of a connector element utilizing both conventional contacts **"A"** and the transmission links **"B"** of the invention, with enlarged detail portions at **"A"** and **"B"** thereof, illustrating the occurrence of inductance in the respective systems;
FIG. 9 is a perspective view of an alternate construction of a link of the invention with a right angle bend formed therein;
FIG. 10 is a schematic view of a transmission line utilizing the links of the present invention;
FIG. 11 is a perspective view illustrating alternate media compositions of the links of the invention;
FIG. 12 is a perspective view of an array of different shapes of dielectric bodies illustrating alternate conductive surface arrangements;
FIG. 13 is a perspective view of an array of non-circular cross-section dielectric bodies that may be used to form links of the invention;
FIG. 14 is a perspective view of another array of non-circular cross-section dielectric bodies suitable for use as links of the invention;
FIG. 15 is an exploded view of a connector assembly incorporating a multiple element link of the invention that is used to provide a transmission line between two connectors;
FIG. 16 is a perspective view of a connector assembly having two connector housings interconnected by the transmission link of FIG. 15;
FIG. 17 is a diagrammatic view of a transmission channel of the present invention with two interconnecting blocks formed at opposite ends of the channel and illustrating the potential flexible nature of the invention;
FIG. 18 is a perspective view of an array of differently configured dielectric bodies that may be used as links of the with different lens characteristics;
FIG. 19 is a perspective view of a multiple transmission link extrusion with different signal channels formed thereon;
FIG. 20 is a perspective view of a multiple transmission link extrusion used in the invention;
FIG. 21 is a perspective view of a mating interface used with a discrete transmission link of the invention, in which mating interface takes the form of a hollow endcap;
FIG. 22 is a rear perspective view of the endcap of FIG. 21, illustrating the center opening thereof that receives an end portion of the transmission link therein;
FIG. 23 is a frontal perspective view of the endcap of FIG. 21, illustrating the orientation of the exterior contacts;
FIG. 24 is a plan view of a multiple transmission link right angle, curved connector assembly;
FIG. 25 is a perspective view of an alternate construction of one of the termination ends of the connector assembly;
FIG. 26 is a perspective view of a connector suitable for use in connecting transmission channel links of the present invention to a circuit board;
FIG. 27A is a skeletal perspective view of the connector of FIG. 26 illustrating, in phantom, some of the internal contacts of the connector;
FIG. 27B is a perspective view of the interior contact assembly of the connector of FIG. 27A, with the sidewalls removed and illustrating the structure and placement of the coupling staple thereon;
FIG. 28 is a cross-sectional view of the connector of FIG. 26, taken along ines 28-28 thereof;
FIG. 29 is a perspective view of a planar triad slot transmission line in a dielectric substrate; and,
FIG. 30 is a sectional view of the substrate shown in FIG. 29 depicting a non-air dielectric filling the slot, the bottom of which is metallized.

### Detailed Description Of The Preferred Embodiments

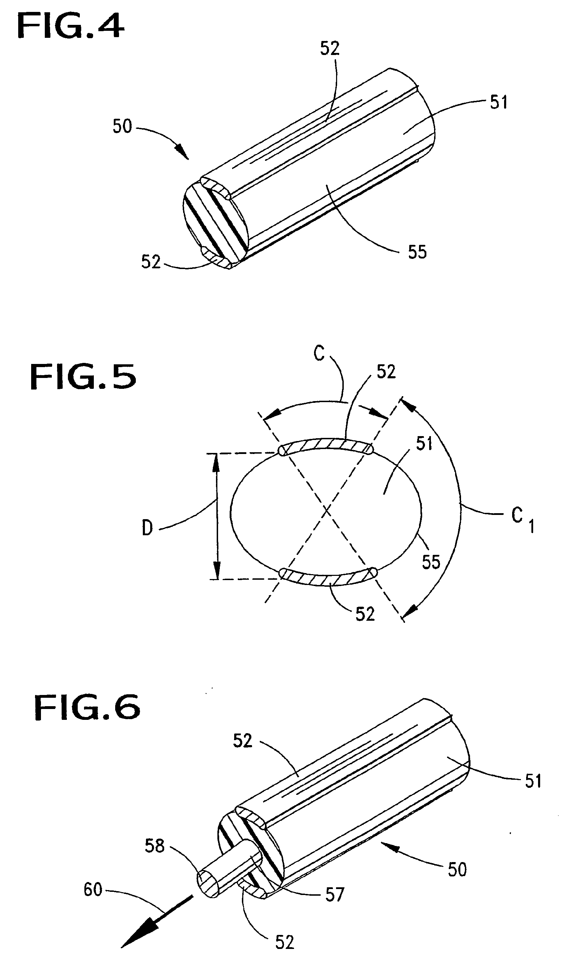

FIG. 4 illustrates a grouped element channel link 50 constructed in accordance with the principles of the present invention. It can be seen that the link 50 includes an elongated, dielectric body 51, preferably a cylindrical filament, that is similar to a length of fiber optic material. It differs therefrom in that the link 50 acts as a pre-engineered wave guide and a dedicated transmission media. In this regard, the body 51 is formed of a dedicated dielectric having a specific dielectric constant and a plurality of conductive elements 52 applied thereto. In FIGS. 4 and 5, the conductive elements 52 are illustrated as elongated extents, traces or strips, 52 of conductive material and, as such, they may be traditional copper or precious metal extents having a definite cross-section that may be molded or otherwise attached, such as by adhesive or other means to the dielectric body of the link 50. They may also be formed on the exterior surface 55 of the body 51 such as by a suitable plating or vacuum deposition process. The conductive traces 52 are disposed on the exterior surface and have a width that extends along the perimeter of the dielectric body.

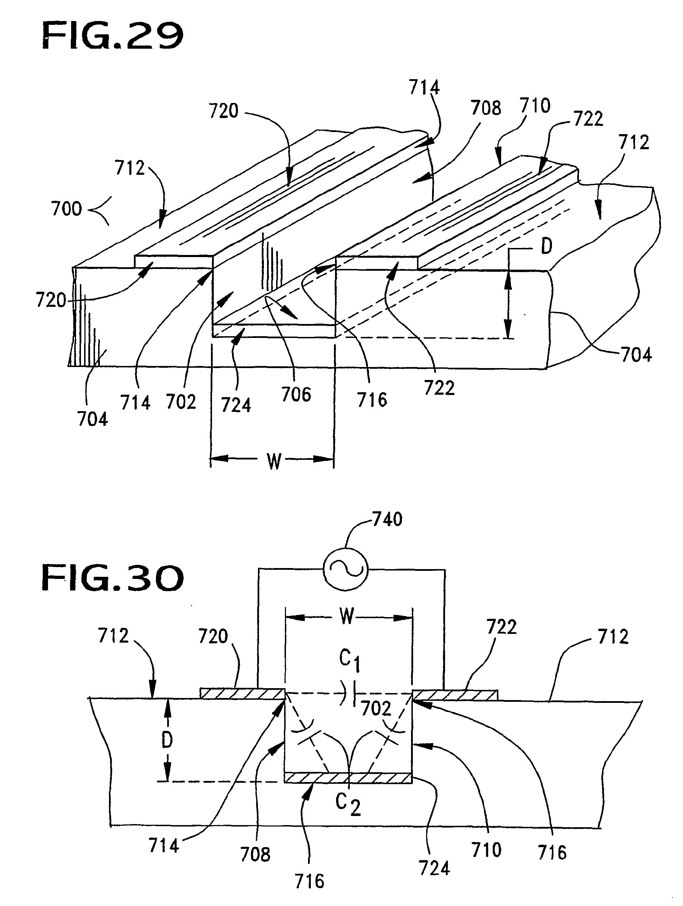

At least two such conductors are used on each link, typically are used for signal conveyance of differential signals, such as +0.5 volts and -0.5 volts. The use of such a differential signal arrangement permits us to characterize structures of this invention as pre-engineered waveguides that are maintained over substantially the entire length of the signal delivery path. The use of the dielectric body 51 provides for preferred coupling to occur within the link. In the simplest embodiment, as illustrated in FIG. 5, the conductive elements are disposed on two opposing faces, so that the electrical affinity of each of the conductive elements is for each other through the dielectric body upon which they are supported, or in the case of a conductive channel as will be explained in greater detail to follow and as illustrated in FIGS. 29-30, the conductive elements are disposed on two or more interior faces of the cavity/cavities to establish the primary coupling mode across the cavity gap and through an air dielectric. In this manner, the links of the present invention may be considered as the electrical equivalent to a fiber optic channel or extent.

The present invention is directed to electrical waveguides. The waveguides of the present invention are intended to maintain electrical signals at desired levels of electrical affinity at high frequencies from about 1.0 Ghz to at least 12.5 Ghz and preferably higher. Optical waveguides, as described in U.S. Pat. No. 6,377,741, issued Apr. 23, 2002, typically rely upon a single outer coating, or cladding, having mirror-like reflective properties to maintain the light particles moving in a selected direction. Openings in the outer coating/cladding will result in a dispersal of the light traveling through the waveguide, which adversely affects the light beam of the waveguide. Microwave waveguides are used at very high frequencies to direct the energy of the microwave beam, rather than transmit it as exemplified by U.S. Pat. No. 6,114,677, issued Sep. 5, 2002 in which a microwave waveguide is used to direct the microwaves at the center portion of an oven. Such a directional aim is also utilized the microwave antenna art. In each instance, these type of waveguides are used to focus and direct the energy of the light of microwave traveling through them, whereas in the present invention, the entire waveguide structure is engineered to maintain an electrical signal at desired frequency(ies) and impedance, capacitance and inductance.

The effectiveness of the links of the present invention are dependent upon the guiding and maintenance of digital signals through the channel link, by utilizing two or more conductive surfaces of electrical containment. This will include maintaining the integrity of the signal, controlling the emissions and minimizing loss through the link. The channel links of the present invention contain the electromagnetic fields of the signals transmitted therethrough by controlling the material of the channel link and the geometries of the system components so that preferred field coupling will be provided. Simply stated, the present invention creates an engineered transmission line by defining a region of electrical affinity, i.e., the dielectric body 51, that is bounded by conductors, i.e., conductive surfaces 52, of opposing charge, i.e., negative and positive differential signals.

As illustrated better in FIG. 5, the two conductive surfaces 52 are arranged on the dielectric body 51 in opposition to each other. The dielectric body 51 shown in FIG. 4 takes the form of a cylindrical rod, while the dielectric body shown in FIG. 5 has an oval-like configuration. In each such instance, the conductive surfaces or traces 52, extend for distinct arc lengths. Both FIGS. 4 and 5 are representative of a "balanced" link of the invention where the circumferential extent, or arc length **C** of the two conductive surfaces 52 is the same, and the circumferential extents or arc lengths **C1** of the non-conductive exterior surfaces 55 of the dielectric body 51 are also the same. This length may be considered to define a gross separation **D** between the conductive surfaces. As will be explained below, the link may be "unbalanced" with one of the conductive surfaces having an arc length that is greater than the other, and in such an instance, the transmission line is best suited for single-ended, or non-differential signal applications. In instances where the dielectric body and link are circular, the link may serve as a contact pin and so be utilized in connector applications. This circular cross-section demonstrates the same type of construction as a conventional round contact pin.

As illustrated in FIG. 6, the links of the present invention may be modified to provide not only multiple conductive elements as part of the overall system transmission media, but may also incorporate a coincident and coaxial fiber optic wave guide therewithin for the transmission of light and optical signals. In this regard, the dielectric body 51 is cored to create a central opening 57 through which an optical fiber 58 extends. Electrical signals may be transmitted through this link as well as light signals 60.

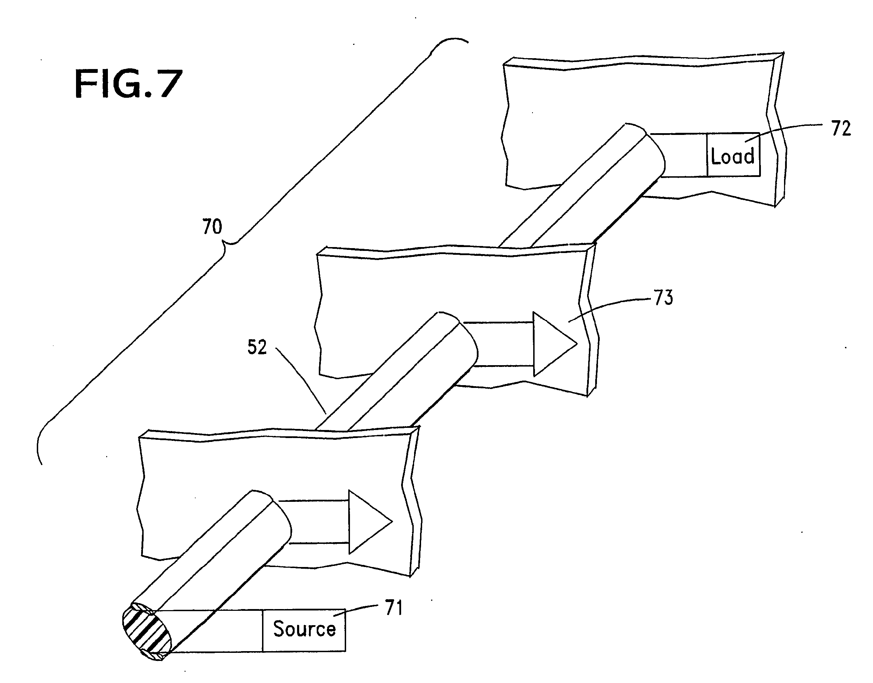

FIG. 7 schematically illustrates a transmission line 70 incorporating a link 50 of the present invention that extends between a source 71 and a load 72. The conductive surfaces 52 of the link serve to interconnect the source and load together, as well as other secondary loads 73 intermediate the source and the load. Such secondary loads may be added to the system to control the impedance through the system. A line impedance is established at the source and may be modified by adding secondary loads to the transmission line.

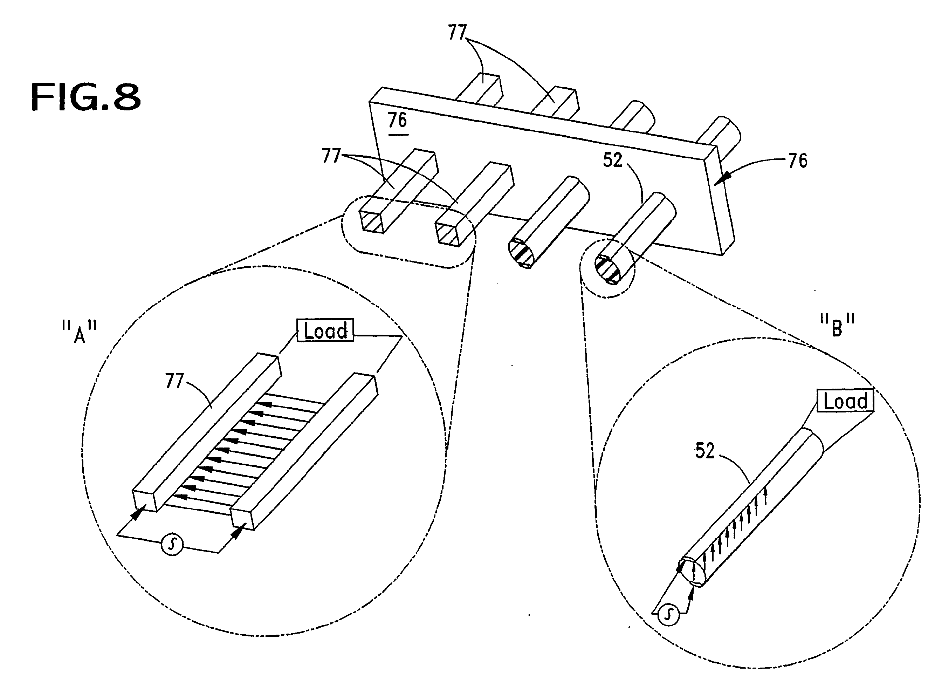

FIG. 8 illustrates, schematically, the difference between the links of the present invention and conventional conductors, which are both illustrated as supported by a dielectric block 76. Two discrete, conventional conductors 77 are formed from copper or another conductive material and extend through the block 76, in the manner of pins. As shown in enlargement "A", the two discrete conductor presents an open cell structure with a large inductance (L) because of the enlarged current loop. Quite differently, the links of the present invention have a smaller inductance (L) at a constant impedance due to the proximity of the conductive surfaces to each other as positioned as the dielectric body 51. The dimensions of these links 50 can be controlled in the manufacturing process and extrusion will be the preferred process of manufacturing with the conductive surfaces being extended with the dielectric body or separately applied of the extrusion, such as by a selective plating process so that the resulting construction is of the plated plastic variety. The volume of the dielectric body 51 and the spacing between conductive elements disposed thereon may be easily controlled such an extrusion process. The conductive surfaces preferably extend for the length of the dielectric body and may end slightly before the ends thereof at a location where it is desired to terminate the transmission line to a connector, circuit board or similar component,

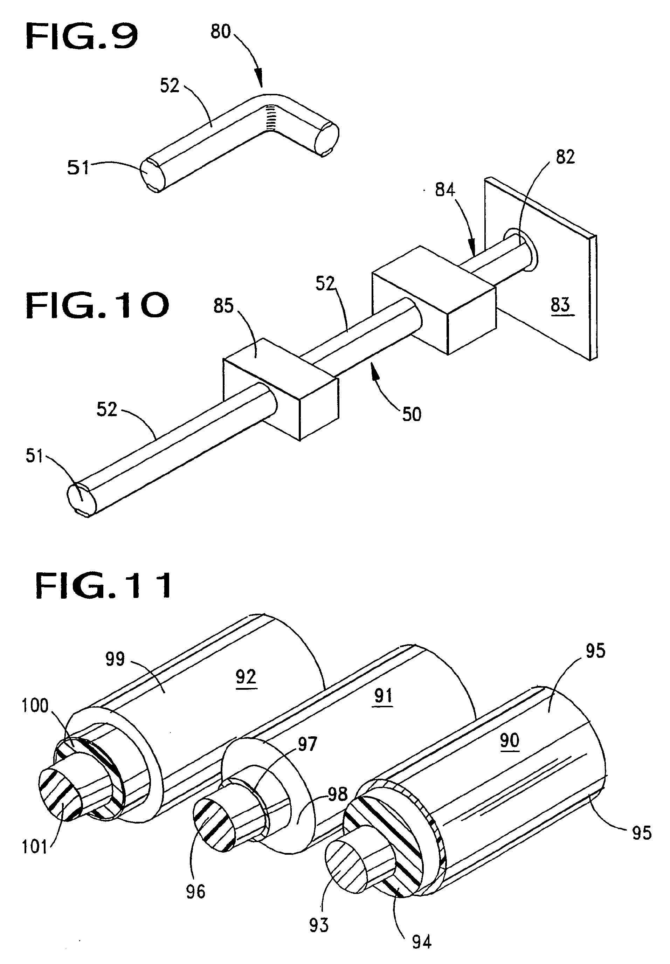

As FIG. 9 illustrates, the dielectric body may have a bend 80 forward therewith in the form of the 90.degree. right-angle bend illustrated or in any other angular orientation. As shown, the conductive surfaces 52 extend through the bend 80 with the same separation spacing between them and the same width with which the conductive surfaces start and end. The dielectric body 51 and the conductive surfaces 52 are easily maintained in their spacing and separation through the bend to eliminate any potential losses

FIG. 10 illustrates a transmission line using the links of the invention. The link 50 is considered as a transmission cable formed from one or more single dielectric bodies 51, and one end 82 of it is terminated to a printed circuit board 83. This termination may be direct in order to minimize any discontinuity at the circuit board. A short transfer link 84 that maintains any discontinuities at a minimum is also provided. These links 84 maintain the grouped aspect of the transmission link. Termination interfaces 85 may be provided where the link is terminated to the connector with minimum geometry discontinuity or impedance discontinuity. In this manner, the grouping of the conductive surfaces is maintained over the length of the transmission line resulting in both geometric and electrical uniformity.

FIG. 11 illustrates a variety of different cross-sections of the transmission links 50 of the invention. In the rightmost link 90, a central conductor 93 is encircled by a hollow dielectric body 94 which in turn, supports multiple conductive surfaces 95 that are separated by an intervening space, preferably filled with portions of the dielectric body 94. This construction is suitable for use in power applications where power is carried by the central conductor 93. In the middle link 91 of FIG. 11, the central cover 96 is preferably made of a selected dielectric and has conductive surfaces 97 supported on it. A protective outer insulative jacket 98 is preferably provided to protect and or insulate the inner link. The leftmost link 92 of FIG. 11 has a protective outer jacket 99 that encloses a plateable polymeric ring 100 that encircles either a conductive or insulative core 101. Portions 101 of the ring 100 are plated with a conductive material and are separated by unplated portions to define the two or more conductive surfaces desired on the body of the ring. Alternatively, one or the elements surrounding the core or of the link 92 may be filled with air and may be spaced away from an inner member by way of suitable standoffs or the like.

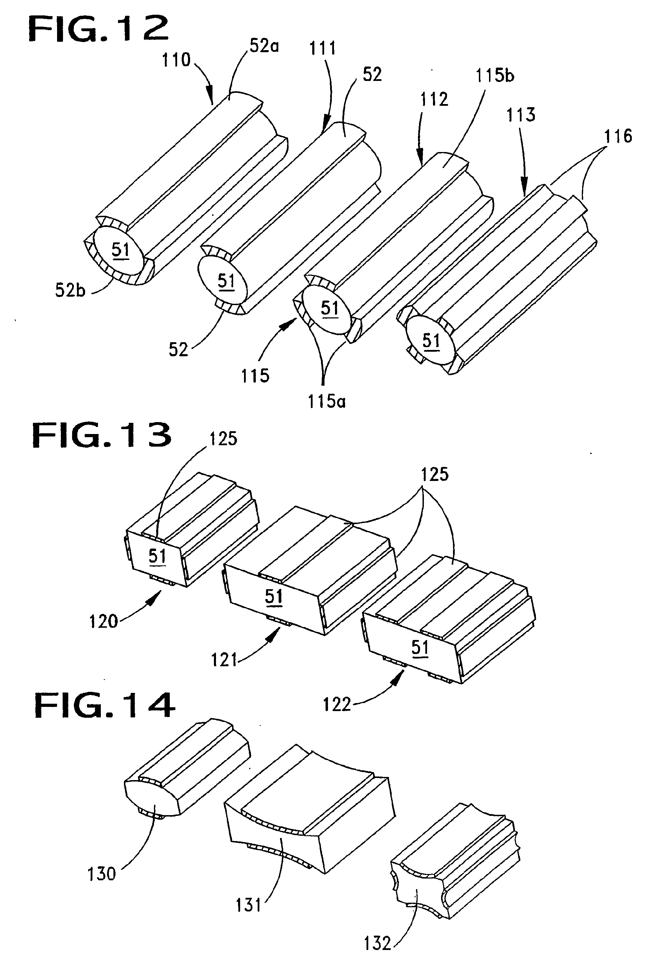

FIG. 12 illustrates an array of links 110-113 that have their outer regions combined with the dielectric body 51 to form different types of transmission links. Link 110 has two conductive surfaces 52a, 52b of different arc lengths (i.e., unbalanced) disposed on the outer surface of the dielectric body 51 so that the link 110 may provide single-ended signal operation. Link 111 has two equal-spaced and sized (or "balanced") conductive elements 52 to provide an effective differential signal operation.

Link 112 has three conductive surfaces 115 to support two differential signal conductors 115a and an assorted ground conductor 115b. Link 113 has four conductive surfaces 116 disposed on its dielectric body 51 in which the conductive surfaces 116 may either include two differential signal channels (or pairs) or a single differential pair with a pair of associated grounds.

FIG. 13 illustrates an array of one-type of non-circular links 120-122 that polygonal configurations, such as square configurations, as with link 120 or rectangular configurations as with links 121-122. The dielectric bodies 51 may be extruded with projecting land portions 125 that are plated or otherwise covered with conductive material. Individual conductive surfaces are disposed on individual sides of the dielectric body and preferably differential signal pairs of the conductive surfaces are arranged on opposing sides of the body. These land portions 125 may be used to "key" into connector slots of terminating connectors in a manner so that contact between the connector terminals (not shown) and the conductive faces 125 is easily effected.

FIG. 14 illustrates some additional dielectric bodies that may be utilized with the present invention. One body 130 is shown as convex, while the other two bodies 131, 132 are shown as being generally concave in configuration. A circular cross-section of the dielectric bodies has a tendency to concentrate the electrical field strength at the corners of the conductive surfaces, while a slightly convex form as shown in body 130, has a tendency to concentrate the field strength evenly, resulting in lower attenuation. The concave bodies, as illustrated by dielectric bodies 131, 132 may have beneficial crosstalk reduction aspects because it focuses the electrical field inwardly. he width or arc lengths of these conductive surfaces, as shown in FIG. 14 are less that the width or arc lengths of the respective body sides supporting them.

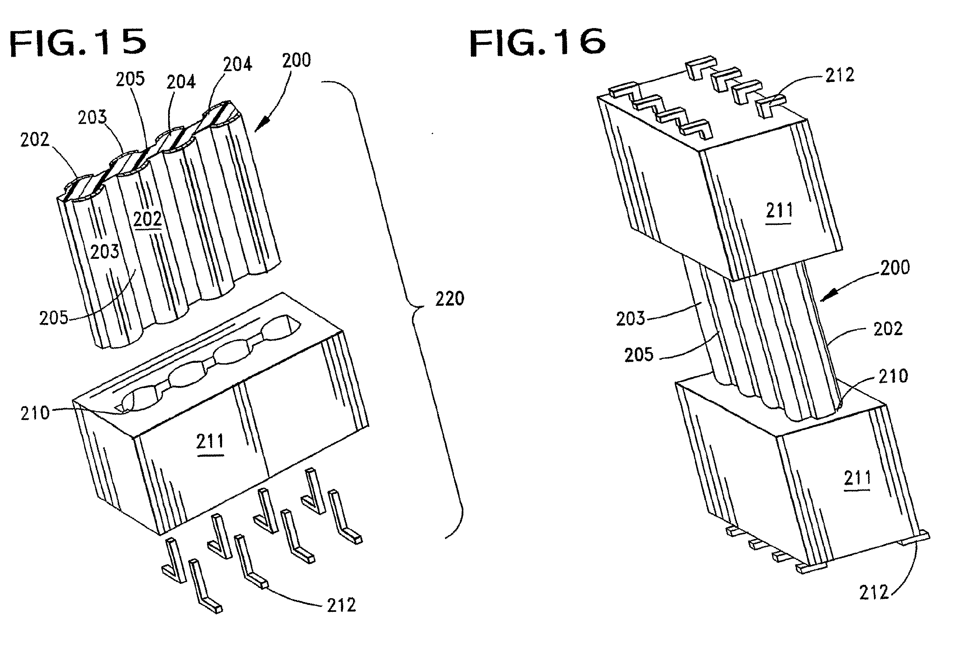

Importantly, the transmission link may be formed as a single extrusion 200 (FIGS. 15-16), preferably from a homogenous dielectric material, carrying multiple signal channels thereupon, with each such channel including a pair of conductive surface 202-203. These conductive surfaces 202, 203 are separated from each other by the intervening dielectric body 204 that supports them, as well as web portions 205 that interconnect them together. This extrusion 200 may be used as part of an overall connector assembly 220, where the extrusion is received into a complementary shaped opening 210 formed in a connector housing 211. The inner walls of the openings 210 may be selectively plated, or contacts 212 may be inserted into the housing 211 to contact the conductive surfaces and provide, if necessary, surface mount or through hole tail portions.

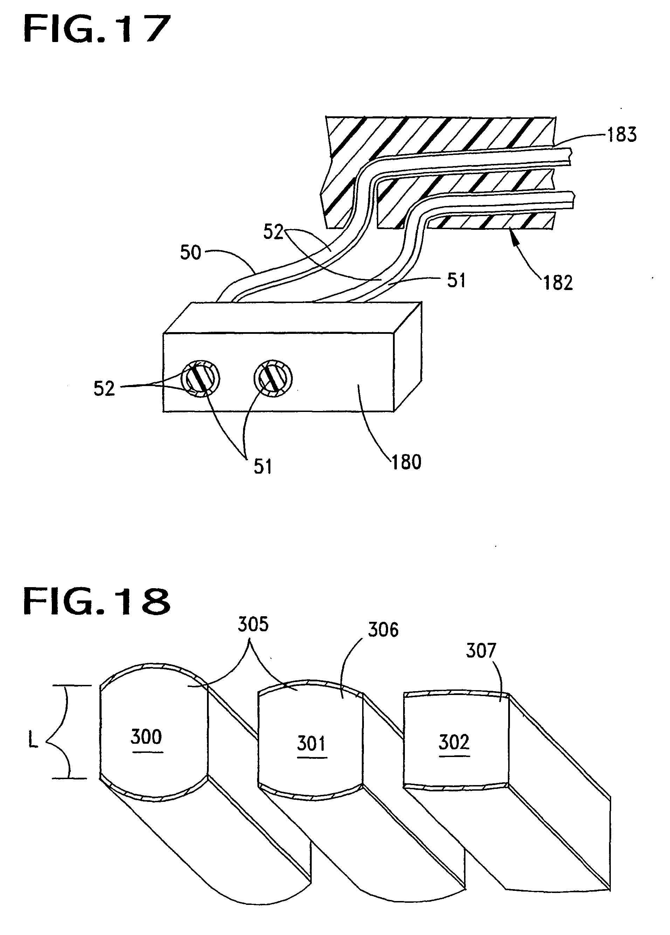

FIG. 17 illustrates the arrangement of two transmission channels 50 arranged as illustrated and terminated at one end to a connector block 180 and passing through a right angle block 182 that includes a series of right angle passages 183 formed therein which receive the transmission channel links as shown. In arrangements such as that shown in FIG. 17, it will be understood that the transmission channel links may be fabricated in a continuous manufacturing process, such as by extrusion, and each such channel may be manufactured with intrinsic or integrated conductive elements 52. In the manufacturing of these elements, the geometry of the transmission channel itself may be controlled, as well as the spacing and positioning of the conductive elements upon the dielectric bodies so that the transmission channels will perform as consistent and unitary electronic waveguides which will support a single channel or "lane" of signal (communication) traffic. Because the dielectric bodies of the transmission channel links may be made rather flexible, the systems of the invention are readily conformable to various pathways over extended lengths without significantly sacrificing the electrical performance of the system. The one connector endblock 180 may maintain the transmission channels in a vertical alignment, while the block 182 may maintain the ends of the transmission channel links in a right angle orientation for termination to other components.

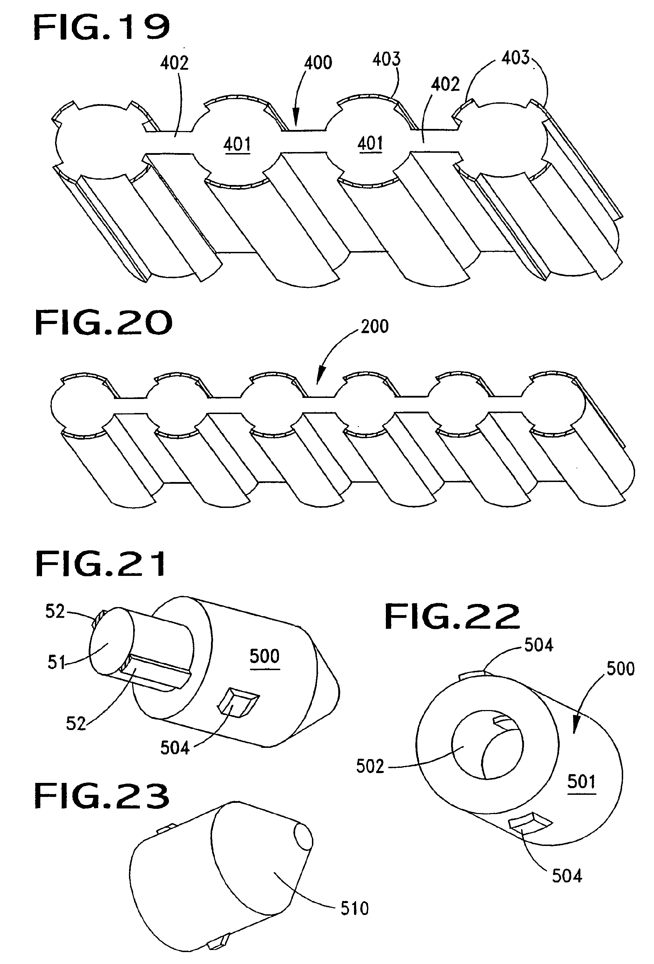

FIG. 18 illustrates a set of convex dielectric blocks or bodies 300-302 in which separation distance **L** varies and the curve 305 of the exterior surfaces 306 of the blocks rises among the links 300-302. In this manner, it should be understood that the shapes of the bodies may be chosen to provide different lens characteristics for focusing the electrical fields developed when the conductive elements are energized. FIG. 19 illustrates a multiple channel extrusion 400 with a series of dielectric bodies or blocks 401 interconnected by webs 402 in which the conductive surfaces 403 are multiple or complex in nature. As with the construction shown in FIG. 13, such an extrusion 400 supports multiple signal channels, with each of the channels preferably including a pair of differential signal conductive elements. FIG. 20 illustrates a standard extrusion 200 such as that shown in FIGS. 15 and 16.

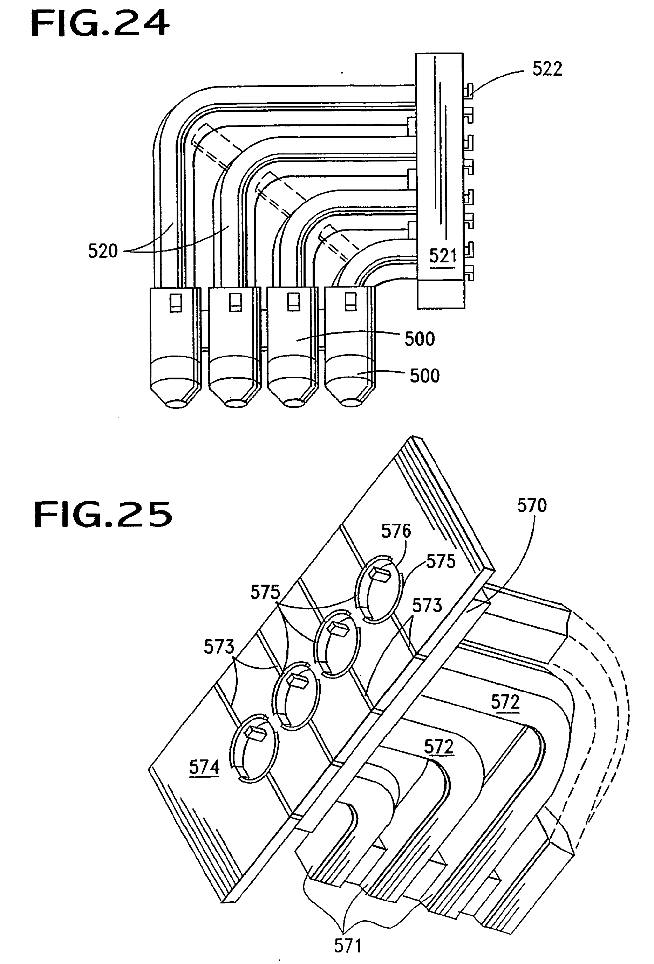

The links of the present invention may be terminated into connector and other housings. FIGS. 21-23 illustrate one termination interface as a somewhat conical endcap which has a hollow body 501 with a central openings 502. The body may support a pair of terminals 504 that mate with the conductive surfaces 52 of the dielectric body 51. The endcap 500 may be inserted into various openings in connector housings or circuit boards and as such, preferably includes a conical insertion end 510. The endcap 500 may be structured to terminate only a single transmission line as is illustrated in FIGS. 21-23, or it may be part of a multiple termination interface and terminate multiple distinct transmission lines as illustrated in FIGS. 24 and 25.

FIG. 24 illustrates the endcaps 500 in place on a series of links 520 that are terminated to an endblock 521 that has surface mount terminals 522 so that the endblock 521 may be attached to a circuit board (not shown). The endcap need not take the conical structure shown in the drawings, but may take other shapes and configurations similar to that shown and described below.

FIG. 25 illustrates an alternate construction of an end block 570. In this arrangement, the transmission lines, or links 571, are formed from a dielectric and include a pair of conductive extents 572 formed on their exterior surfaces (with the extents 572 shown only on one side for clarity and their corresponding extents being formed on the surfaces of the links 571 that face into the plane of the paper of FIG. 25). These conductive extents 572 are connected to traces 573 on a circuit board 574 by way of conductive vias 575 formed on the interior of the circuit board 574. Such vias may also be constructed within the body of the end block 570, if desired. The vias 575 are preferably split as shown and their two conductive sections are separated by an intervening gap 576 to maintain separation of the two conductive transmission channels at the level of the board.

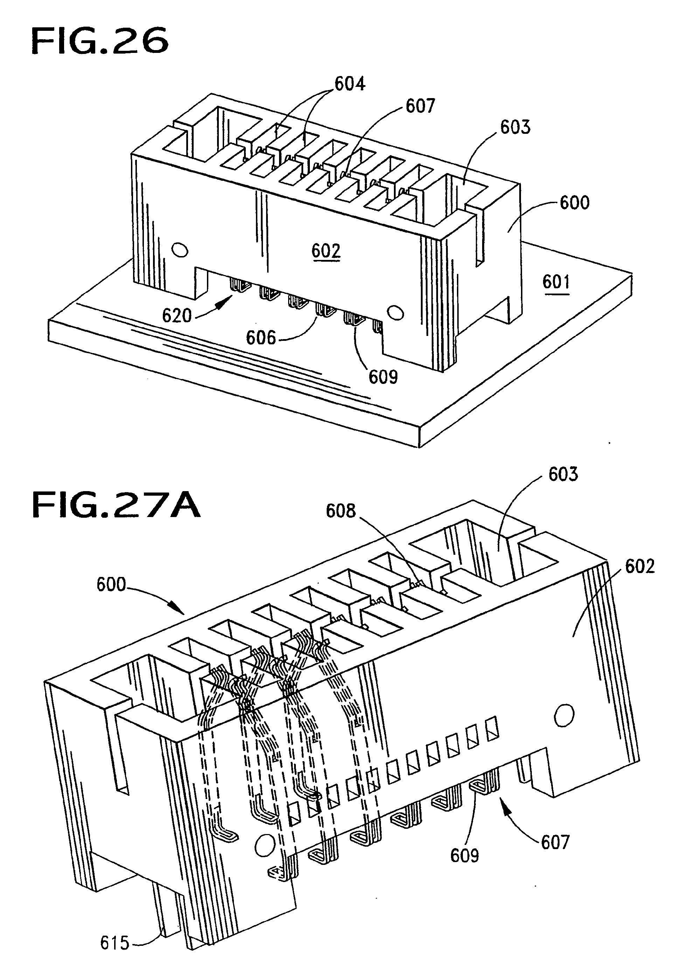

FIG. 26 illustrates an endcap, or block 600 mounted to a printed circuit board 601. This style of endcap 600 serves as a connector and thus includes a housing 602, with a central slot 603 with various keyways 604 that accept projecting portions of the transmission link. The endcap connector 600 may have a plurality of windows 620 for access to soldering the conductive tail portions 606 of the contacts 607 to corresponding opposing traces on the circuit board 601. In instances of surface mount tails a shown, the tails 606 may have their horizontal parts 609 tucked under the body of the endcap housing to reduce the circuit board pad size needed, as well as the capacitance of the system at the circuit board.

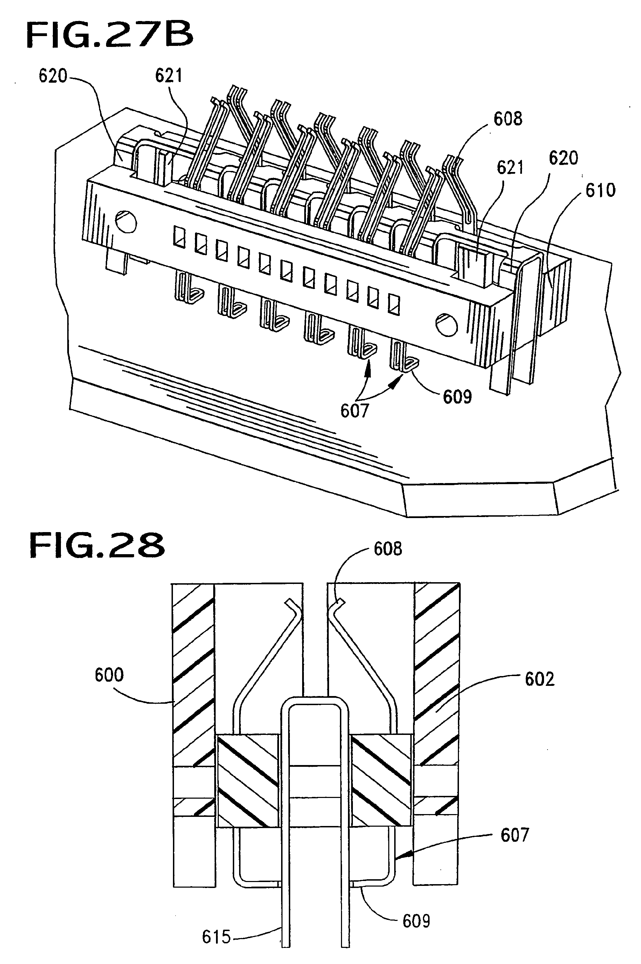

FIG. 27A illustrates a partial skeletal view of the endcap connector 600 and shows how the contacts, or terminals 607 are supported within and extend through the connector housing 602. The terminals 607 may include a dual wire contact end 608 for redundancy in contact (and for providing a parallel electrical path) and the connector 600 may include a coupling staple 615 that has an inverted U-shape and which enhances coupling of the terminals across the housing. The coupling staple 615 can be seen to have an elongated backbone that extends lengthwise through the connector housing 602. A plurality of legs that are spaced apart from each other by spaces along the length of the coupling staple extend down toward the circuit board and each such leg has a width that is greater than a corresponding width of the terminal that it opposes. As shown in the drawings, the coupling staple legs are positioned in alignment with the terminals. The tail portions of these dual wire terminals 607 enhance the stability of the connector. In this regard, it also provides control for the terminals that constitute a channel (laterally) across the housing slot 601. The dual contact path not only provides for path redundancy but also reduces the inductance of the system through the terminals. FIG. 27B is a view of the interior contact assembly that is used in the endcap connector 600 of FIGS. 26 and 27A. The terminals 607 are arranged on opposite sides of the connector and are mounted within respective support blocks 610. These support blocks 610 are spaced apart from each other a preselected distance that assists in spacing the terminal contacts 608 apart.

A conductive coupling staple 615 having an overall U-shape, or blade shape, may be provided and may be interposed between the terminals 607 and support blocks 610 to enhance the coupling between and among the terminals 607. The coupling staple 615 has a series of blades 620 that are spaced apart by intervening spaces 621 and which are interposed between pairs of opposing contacts (FIG. 28) 6087and which extend downwardly toward the surface of the circuit board. The staple 615 extends lengthwise through the connector body between the connector blocks 610. The connector blocks 610 and the connector housing 602 (particularly the sidewalls thereof) may have openings 616 formed therein that receive engagement plugs 617 therein to hold the two members in registration with each other. Other means of attachment may be utilized, as well. FIG. 28 is an end view of the connector 600, which illustrates the interposition of the coupling staple between a pair of opposing contacts 608 and the engagement of the connector blocks 610 and the connector housing 602.

Notwithstanding all of the foregoing, FIG. 29 illustrates a three-conductor transmission line 700, the cross-section of the elements of which can be sized and arranged to conform to the triangular arrangement of conductors in the aforementioned "triad" type of connector. In the transmission line 700 of FIG. 29, two signal conductors carry differential signals.

The transmission line is formed by a slot 702, cut or formed through a dielectric substrate 704. In a preferred embodiment, the substrate 704 is a circuit board, well known to those of ordinary skill in the art to be a planar, non-conductive or dielectric, material that is capable of supporting electronic components such as integrated circuits, passive electronic devices but also "triad" type connectors. The substrate 704 could also be made from materials such as plastic, glass or fiberglass, which are typically used int eh manufacture of circuit boards. In at least one alternate embodiment, the substrate 704 is an integrated circuit substrate material, one of which is well known to those of skill in the art as amorphous silicon.

The slot 702 is formed into the substrate 704 using processes dictated by the substrate 704 size and the material from which it is made. The slot can be cut, abraded or machined into a circuit board. It can also be cut, machined, abraded or chemically etched into glass. For integrated circuit substrates, the slot 702 can be etched or formed by masking the slot bottom 706 and building up the material on either side thereof so as to form the sidewalls 708 and 710. Another method of forming the slot in an integrated circuit is disclosed in U.S. Pat. No. 5,501,893, which discloses anisotropic silicon etching, the teachings of which are incorporated herein by reference.

It can be seen in FIG. 29 that the sidewalls 708 and 710 and the top 712 of the substrate 704 are substantially planar and orthogonal to each other. The intersection of the planar top 712 and the "left" sidewall 708 forms an edge 714 that runs the length of the slot 702. The intersection of the planar top 712 and the "right" sidewall 710 forms another edge 716, but which is not readily seen in FIG. 29 and which also runs the length of the slot 702.

Along each of the aforementioned edges 714 and 716 is a relatively thin, relatively narrow strip of conductive material 720 and 722, deposited on the top 712 of the substrate 704. In addition to the top-surface strips 720 and 722, a thin strip of conductive material 724 is deposited onto the bottom 706 of the slot 702. The composition of the conductive strips 720, 722 and 724 will depend on the substrate 704. One or more of the conductive strips 720, 722 and 724 could be metal-plating if the substrate 704 is of an appropriate material that will accept metal plating. Various plastics are known to be metal plateable. One or more of the conductive strips could be formed from adhesive-backed metal strips that are simply applied to the substrate. In embodiments where the substrate is an integrated circuit, the conductive strips 720, 722 and 724 could be formed on the substrate surface by sputtering, vapor deposition or by etching away metal that is deposited over the entire upper surface 712.

As shown in FIG. 29, the conductive strips 720 and 724 on the top 712 surface follow the edges 714, 716 of the slot 702. As is also shown in FIG. 29, the surface area of each of the strip conductors 720 and 724 that face each other is quite small, i.e., only the thickness of each conductor 720, 724. As a result, the capacitive coupling between the two conductors 720 and 724 is reduced below the coupling that would exist if the opposing sidewalls 708 and 710 were metallized and conducted signals thereon.

The depth **D** of the slot 702 and the slot's width **W** can both be determined so that when the conductive strips 720, 722 and 724 are applied to their corresponding surfaces on the dielectric 704, their sizes and locations with respect to each other, conforms to the triangular spacing used with "triad" type connectors. By way of example, the slots depth **D** can be increased or decreased to increase or decrease the "vertical" distance between the surface 712 and the bottom 706 of the slot 702. The width **W** can be increased as well. By matching the conductors' location with respect to each other, one may determine the capacitance of the system and therefore calculate the impedance of the system so that target impedances may be achieved along the length of the transmission line.

FIG. 30 is an end view of the three-conductor transmission line 700. It can be seen that the depth **D** and width **W** of the slot 702 can be increased or decreased as needed (subject to the thickness and width dimension of the substrate) to match the triangular conductor spacing of a "triad" connector. FIG. 30 also shows a high-frequency signal source 740 coupled to the conductive strips 720 and 722 on the "upper" surface 712 of the substrate 704. Signals from the source 740 are bi-polar, i.e., the signal's excursion is above and below zero volts by an equal amount. Accordingly, the conductive strips 720 and 722 are considered to be carrying "differential signals" and the strips 720 and 722 can be considered a differential pair. The capacitive coupling between the strips 720 and 722 is largely determined by the surface area of the strips 720 and 722 that face each other, but also by the spacing distance **D** between them. The capacitance between the two strips is represented in FIG. 30 by C₁.

An enhanced-performance three-conductor transmission line that matches or conforms to the spacing of conductors in a "triad" connector is realized by matching the strip spacing to a corresponding connector. In FIG. 30, the slot's bottom conductor 722 is held at ground (or other reference potential voltage) for differential signals carried on the thin, conductive strips 720, 722 that are on the top 712 of the dielectric substrate 704. In so doing, the ground strip tends to reduce signal emissions from the strips 720 and 722, in part because of the capacitance between the signal strips 720, 722 and the ground strip 724. This capacitance is represented in FIG. 30 by **C₂.**

The ground strip 724 on the slot bottom 716 with the differential pair 720, 722 also can be considered to comprise a "triad" and for purposes of claim construction, the transmission line 700 is considered to be a "triad" transmission line. Such transmission lines are considered to have superior high-frequency signal performance, at least up to approximately 4- 8 Ghz and can provide useful impedance control through geometrical transitions arranged on the circuit board or other substrate.

In a preferred embodiment, the slot 702 is formed through only one of the surfaces of the planar dielectric substrate. For purposes of illustration only, the surface identified by reference numeral 712 is considered an "upper" or "top" surface. In reality, the slot 702 can be cut or formed through either surface of a dielectric substrate.

In a preferred embodiment, air fills the gap that results from cutting or forming a slot 702 through a solid dielectric. The slot 702 can be readily filled with a non-air dielectric. The capacitive coupling **C₁** in such a case can be increased or decreased, depending upon the particular substrate material used to fill the slot 702.

Those of ordinary skill in the art should appreciate that the conductor triad (720, 722 and 724) can be considered to be a transmission channel or "link" as described above. Those of ordinary skill in the art should also appreciate that two or more such links could be readily formed in a substrate, however, for simplicity and clarity, only one such link is shown in FIG. 29 and 30.

A reduced-cross-sectional area, triad transmission line can be readily constructed by plating or metallizing surface along the edge of a slot cut through a dielectric substrate. The cross-sectional area of such conductors that faces each other is reduced, reducing the signal coupling between them when they are carrying high-frequency signals. By separating them by a dielectric and providing an intervening ground plane between them, a reduced cross-section triad transmission line results with improved signal transmission.

## Claims

1. A transmission line (700) comprising:
a substantially planar dielectric substrate (704) having upper and lower opposing surfaces; and
a slot (702) formed through the upper surface of said dielectric substrate (704), said slot (702) having first and second opposing faces (708,710) spaced apart from each other by an intervening space, the intersection of said first opposing face (78) with the upper surface (712) defining a first slot edge (714), and the intersection of said second opposing face (710) with the upper surface (712) defining a second-slot edge (716),
a first differential signal strip (722) on the upper surface following said first slot edge (714)
a second differential strip on the upper surface following said second-slot edge (716)
**characterised in that** the transmission line (700) further comprises: a planar ground conductor (724) disposed on, and substantially covering the lower surface of the slot (702), said ground conductor being at a reference potential for signals carried on the first and second differential strips (720,722).

2. The transmission line (700) of claim 1, **characterised in that** at least one of the slot's (702) width and depth are sized to match a triad connector.

3. The transmission line (700) of claim 1, **characterised in that** the line includes a non-air dielectric in said slot (702).

## Patentansprüche

1. Übertragungsleitung (700), umfassend:
ein im Wesentlichen planares dielektrisches Substrat (704) mit sich gegenüberliegenden oberen und unteren Oberflächen; und
einen Schlitz (702), gebildet durch die obere Oberfläche des dielektrischen Substrats (704), wobei der Schlitz (702) erste und zweite gegenüberliegende Flächen (708, 710) aufweist, voneinander getrennt durch einen Zwischenraum, wobei der Schnitt der ersten gegenüberliegenden Fläche (708) mit der oberen Oberfläche (712) eine erste Schlitzkante (714) definiert, und der Schnitt der zweiten gegenüberliegenden Fläche (710) mit der oberen Oberfläche (712) eine zweite Schlitzkante (716) definiert,
einen ersten differentiellen Signalstreifen (722) auf der oberen Oberfläche, der der ersten Schlitzkante (714) folgt,
einen zweien differentiellen Signalstreifen auf der oberen Oberfläche, der der zweiten Schlitzkante (716) folgt,
**dadurch gekennzeichnet, dass** die Übertragungsleitung (700) weiterhin umfasst:
einen planaren Erdungsleiter (724), angeordnet auf der unteren Oberfläche des Schlitzes (702) und diese im Wesentlichen bedeckend, wobei der Erdungsleiter auf einem Referenzpotential für Signale liegt, die über den ersten und zweiten differentiellen Streifen (720, 722) geleitet werden.

2. Übertragungsleitung (700) nach Anspruch 1, **dadurch gekennzeichnet, dass** mindestens eines von: der Weite und der Tiefe des Schlitzes (702) so bemessen ist, dass sie einem Triadenanschluss entspricht.

3. Übertragungsleitung (700) nach Anspruch 1, **dadurch gekennzeichnet, dass** die Leitung ein Nicht-Luft-Dielektrikum in dem Schlitz (702) aufweist.

## Revendications

1. Ligne de transmission (700) comportant :
un substrat diélectrique (704) essentiellement plan ayant des surfaces supérieure et inférieure opposées ; et
une fente (702) formée à travers la surface supérieure dudit substrat diélectrique (704), ladite fente (702) ayant une première et une seconde face opposées (708, 710) espacées entre elles d'un intervalle intermédiaire, l'intersection entre ladite première face opposée (708) et la surface supérieure (712) définissant un premier bord de fente (714) et l'intersection entre ladite seconde face opposée (710) et la surface supérieure (712) définissant un second bord de fente (716),
un première bande différentielle de signal (722) sur la surface supérieure suivant ledit premier bord de fente (714),
une seconde bande différentielle sur la surface supérieure suivent ledit second bord de fente (716),
**caractérisée en ce que** la ligne de transmission comprend en outre :
un conducteur plan de fond (724) disposé sur la surface inférieure de la fente (702) et pratiquement la recouvrant, ledit conducteur plan de fond étant à un potentiel de référence pour des signaux transmis par la première et la seconde brande différentielle (720, 722).

2. Ligne de transmission (700) selon la revendication 1, **caractérisée en ce qu'**au moins une largeur ou profondeur des fentes (702) est dimensionnée pour correspondre à un connecteur adapté.

3. Ligne de transmission (700) selon la revendication 1, **caractérisée en ce que** la ligne comporte un diélectrique sans air dans ladite fente (702).
